(19) Europäisches Patentamt / European Patent Office / Office européen des brevets

(11) **EP 3 595 017 B1**

(12) **EUROPEAN PATENT SPECIFICATION**

(45) Date of publication and mention
of the grant of the patent:
**28.09.2022 Bulletin 2022/39**

(21) Application number: **17899526.2**

(22) Date of filing: **08.03.2017**

(51) International Patent Classification (IPC):
**H01L 51/42** *(2006.01)*    *H01L 51/50* *(2006.01)*

(52) Cooperative Patent Classification (CPC):
**H01L 51/4246;** H01L 51/502; Y02E 10/542;
Y02E 10/549; Y02P 70/50

(86) International application number:
**PCT/JP2017/009272**

(87) International publication number:
**WO 2018/163327 (13.09.2018 Gazette 2018/37)**

(54) **LIGHT ABSORPTION LAYER, PHOTOELECTRIC CONVERSION ELEMENT, AND SOLAR CELL**

LICHTABSORPTIONSSCHICHT, ELEMENT ZUR PHOTOELEKTRISCHEN UMWANDLUNG UND SOLARZELLE

COUCHE D'ABSORPTION DE LUMIÈRE, ÉLÉMENT DE CONVERSION PHOTOÉLECTRIQUE ET CELLULE SOLAIRE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**15.01.2020 Bulletin 2020/03**

(73) Proprietor: **Kao Corporation**
**Chuo-ku**
**Tokyo 103-8210 (JP)**

(72) Inventors:
• **HOSOKAWA, Hiroji**
**Wakayama-shi**
**Wakayama 640-8580 (JP)**
• **SAWADA, Takuya**
**Wakayama-shi**
**Wakayama 640-8580 (JP)**

(74) Representative: **Hoffmann Eitle**
**Patent- und Rechtsanwälte PartmbB**
**Arabellastraße 30**
**81925 München (DE)**

(56) References cited:
**WO-A2-2016/109902     US-A1- 2016 380 136**

• **ZHILONG ZHANG ET AL: "Effect of Halide Treatments on PbSe Quantum Dot Thin Films: Stability, Hot Carrier Lifetime, and Application to Photovoltaics", JOURNAL OF PHYSICAL CHEMISTRY C, vol. 119, no. 42, 12 October 2015 (2015-10-12), pages 24149-24155, XP055732740, US ISSN: 1932-7447, DOI: 10.1021/acs.jpcc.5b08021**
• **JIANBING ZHANG ET AL: "PbSe Quantum Dot Solar Cells with More than 6% Efficiency Fabricated in Ambient Atmosphere", NANO LETTERS, vol. 14, no. 10, 19 September 2014 (2014-09-19), pages 6010-6015, XP055731947, US ISSN: 1530-6984, DOI: 10.1021/nl503085v**
• **R.WANG et al.: "Colloidal quantum dot ligand engineering for high performance solar cells", Energy & Environmental Science, vol. 9, no. 4, April 2016 (2016-04), pages 1130-1143, XP055551261,**
• **A.H.IP et al.: "Hybrid passivated colloidal quantum dot solids", Nature Nanotechnology, vol. 7, no. 9, September 2012 (2012-09), pages 577-582, XP055331187,**
• **Z.NING et al.: "All-Inorganic Colloidal Quantum Dot Photovoltaics Employing Solution-Phase Halide Passivation", Advanced Materials, vol. 24, no. 47, December 2012 (2012-12), pages 6295-6299, XP055551271,**

EP 3 595 017 B1

- **J.ZHANG et al.: "Diffusion-Controlled Synthesis of PbS and PbSe Quantum Dots with in situ Halide Passivation for Quantum Dot Solar Cells", ACS Nano, vol. 8, no. 1, January 2014 (2014-01), pages 614-622, XP055406141,**
- **Z.YANG et al.: "Colloidal Quantum dot Photovoltaics Enhanced by Perovskite Shelling", Nano Letters, vol. 15, no. 11, November 2015 (2015-11), pages 7539-7543, XP055460579,**
- **Zhijun Ning ET AL: "Quantum-dot-in-perovskite solids", Nature, vol. 523, no. 7560, 15 July 2015 (2015-07-15), pages 324-328, XP055420894, London ISSN: 0028-0836, DOI: 10.1038/nature14563 & Ning: "Extended Data Figure 4: Compositional analysis of PHC.", , 15 July 2015 (2015-07-15), XP055908143, Retrieved from the Internet: URL:https://www.nature.com/articles/nature 14563/figures/8 [retrieved on 2022-04-01]**
- **Dastidar Subham ET AL: "High Chloride Doping Levels Stabilize the Perovskite Phase of Cesium Lead Iodide", Nano Letters, vol. 16, no. 6, 13 May 2016 (2016-05-13), pages 3563-3570, XP055908144, US ISSN: 1530-6984, DOI: 10.1021/acs.nanolett.6b00635**
- **Ning Zhijun ET AL: "All-Inorganic Colloidal Quantum Dot Photovoltaics Employing Solution-Phase Halide Passivation", Advanced Materials, vol. 24, no. 47, 12 September 2012 (2012-09-12), pages 6295-6299, XP055908145, DE ISSN: 0935-9648, DOI: 10.1002/adma.201202942**
- **Zhang Zhilong ET AL: "Supporting Information Effect of Halide Treatments on PbSe Quantum Dot Thin Films: Stability, Hot Carrier Lifetime, and Application to Photovoltaics", , 5 October 2015 (2015-10-05), XP055908243, Retrieved from the Internet: URL:https://pubs.acs.org/doi/suppl/10.1021 /acs.jpcc.5b08021/suppl_file/jp5b08021_si_ 001.pdf [retrieved on 2022-04-04]**

**Description**

TECHNICAL FIELD

The present invention relates to a light absorption layer, a photoelectric conversion element having the light absorption layer, and a solar cell having the photoelectric conversion element.

BACKGROUND ART

A photoelectric conversion element that converts light energy into electric energy is used for solar cells, optical sensors, copying machines, and the like. In particular, from the viewpoint of environmental and energy problems, photoelectric conversion elements (solar cells) utilizing sunlight that is an inexhaustible clean energy attract attention.

Since general silicon solar cells utilize ultra-high purity silicon and are manufactured by "dry process" such as epitaxial crystal growth under high vacuum, it is not possible to expect a large cost reduction. Therefore, a solar cell manufactured by a "wet process" such as a coating process is expected as a low-cost next generation solar cell.

A quantum dot solar cell is a next-generation solar cell that can be manufactured by the "wet process". The quantum dot is an inorganic nanoparticle having a particle size of about 20 nm or less and a crystal structure, and exhibits physical properties different from those of bulk bodies due to the expression of quantum size effect. For example, it is known that the band gap energy increases (shortening of the absorption wavelength) as the particle size of quantum dots decreases, and lead sulfide (PbS) quantum dots having a particle size of about 3 nm and a band gap energy of about 1.2 eV have been reported for use in quantum dot solar cells (ACS Nano 2014, 8, 614-622). A quantum dot solar cell, type examples thereof including PbS or PbSe quantum dot, can attain photoelectric conversion in a near-infrared light region (800 to 2500 nm). However, the band gap energy thereof is small so that the solar cell cannot gain a high voltage to be low in conversion efficiency.

There is a perovskite solar cell as the most promising candidate for the next generation solar cell, which has been recently reported to show a rapid increase in photoelectric conversion efficiency. This perovskite solar cell is provided with a photoelectric conversion element using a perovskite compound ($CH_3NH_3PbI_3$) composed of a cation (such as methyl ammonium) and a halogenated metal salt (such as lead iodide) for the light absorption layer (J. Am. Chem. Soc. 2009, 131, 6050-6051). The perovskite solar cell can attain photoelectric conversion in a visible light region (400 to 800 nm) and shows a relatively high conversion efficiency. However, the perovskite solar cell cannot utilize a near-infrared light region to be insufficient in effective utilization of sunlight.

In recent years, A quantum dot solar cell has been reported which make use of PbS quantum dots surface-treated with a perovskite compound ($CH_3NH_3PbI_3$) in a light absorption layer (Nano Lett. 2015, 15, 7539-7543). However, the perovskite compound is small in quantity so that the compound hardly contributes to power generation. Thus, the solar cell is insufficient in conversion efficiency.

A light absorption layer comprising PbSe quantum dots that contain a halogen element as well as some organic ligands, i.e. in a molar ratio to Pb of 0.333, has been disclosed (J. Phys. Chem. 2015, 119(42), 24149-24155).

US 2016/380136 A1 discloses a light absorption layer comprising a perovskite and quantum containing a halogen element and a organic ligand.

SUMMARY OF THE INVENTION

The invention is set out in the appended set of claims.

The present invention relates to a light absorption layer for forming a photoelectric conversion element and a solar cell which can attain photoelectric conversion in both of a visible light region and a near-infrared light region and which are high in conversion efficiency; and a photoelectric conversion element and a solar cell each having this light absorption layer.

The inventors have found out that a photoelectric conversion element and a solar cell are improved in photoelectric conversion efficiency by using a light absorption layer including a perovskite compound, and a quantum dot containing a halogen element and an organic ligand.

The present invention is related to a light absorption layer including a perovskite compound, and a quantum dot containing a halogen element and an organic ligand, wherein a molar ratio of the organic ligand to a metal element constituting the quantum dot is 0.01 or more and 0.4 or less, wherein the quantum dot containing the halogen element and the organic ligand is such that a molar ratio of the organic ligand to a metal element constituting the perovskite compound is 0.001 or more and 0.1 or less

The use of a perovskite compound and a quantum dot containing a halogen element and an organic ligand as materials for forming a light absorption layer makes it possible to absorb light in a wide wavelength region including not only light in a short wavelength region, which the perovskite compound can absorb, but also light in a long wavelength region, such as a near-infrared light region, which the quantum dot containing the halogen element and the organic ligand can absorb. Thus, a photoelectric conversion element can be obtained which has a photoelectric conversion function in the wide wavelength region.

Moreover, the use of the quantum dot containing the halogen element makes the following better than the use of a quantum dot containing no a halogen element: the photoelectric conversion efficiency of a composite film (light absorption layer) containing the perovskite compound and the quantum dot containing the halogen element. The reason therefor is not clear, but it is presumed as follows.

The presence of the halogen element in the surface of the quantum dot makes it possible to decrease the quantity of any organic ligand (for example, oleate anion) in the surface of the quantum dot to improve the dispersibility of the quantum dot in the light absorption layer and in a dispersion (for example, a liquid in which N,N-dimethylformamide is a solvent). As a result, the light absorption layer can be obtained to include the perovskite compound high in crystallinity (large in crystallite diameter) and to be high in coverage and quality. Thus, the light absorption layer is improved in photoelectric conversion efficiency. Such a reason is presumed. It is also presumed that the presence of the halogen element in the surface of the quantum dot restrains the transfer of carriers from the perovskite compound to the quantum dot so that an efficiency of taking out carriers from the perovskite compound is improved. Thus, the light absorption layer is improved in photoelectric conversion efficiency.

When the quantum dot containing the organic ligand together with the halogen element is used, a ligand exchange is caused between the organic ligand and a precursor of the perovskite compound to form, with ease, a quantum dot in which the precursor of the perovskite compound is coordinated. As a result, a light absorption layer is easily obtained which includes a complex of the perovskite compound and the quantum dot. By the formation of the complex of the perovskite compound and the quantum dot, it is possible not only to cause the quantum dot to be present uniformly in the crystal structure of the perovskite compound but also to make an interface structure between the perovskite compound and the quantum dot uniform at an atomic and molecular level, so that the light absorption layer is improved in photoelectric conversion efficiency. Such a matter is presumed.

In the light absorption layer, the molar ratio of the organic ligand to the metal element constituting the quantum dot is 0.01 or more, preferably 0.05 or more, more preferably 0.09 or more, still more preferably 0.10 or more, and is 0.4 or less, preferably 0.3 or less, more preferably 0.2 or less, still more preferably 0.15 or less, from the viewpoint of improving the dispersibility of the quantum dots in the light absorption layer and exhibiting excellent performance.

The present invention makes it possible to obtain a photoelectric conversion element and a solar cell which can attain photoelectric conversion in both of a visible light region and a near-infrared light region, and which are high in conversion efficiency.

BRIEF DESCRIPTION OF THE DRAWINGS

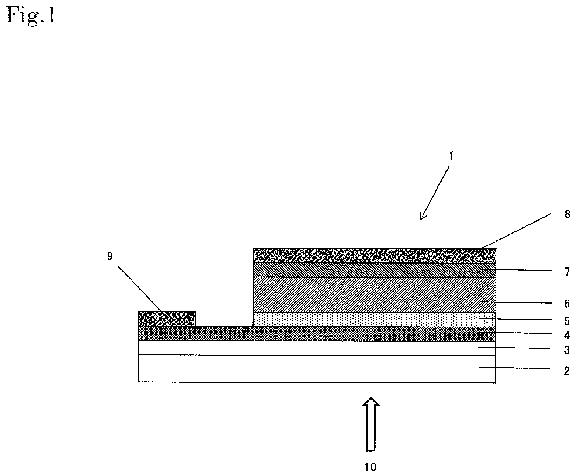

Fig. 1 is a schematic cross-sectional view showing an example of the structure of a photoelectric conversion element of the present invention.

MODE FOR CARRYING OUT THE INVENTION

<Light Absorption Layer>

The light absorption layer of the present invention includes, as a light absorption agent, a perovskite compound, and a quantum dot containing a halogen element and an organic ligand. The light absorption layer of the present invention may include any light absorption agent other than the above-mentioned light absorption agent as long as the advantageous effects of the present invention are not damaged.

The light absorption layer contributes to charge separation of the photoelectric conversion element and has a function of transporting respectively electrons and holes generated by light absorption toward electrodes in the opposite directions and is also called as a charge separation layer or a photoelectric conversion layer.

The perovskite compound is not particularly limited, and is preferably one or more kinds selected from a compound represented by the following general formula (1) and a compound represented by the following general formula (2), more preferably a compound represented by the following general formula (1) from the viewpoint of improving the photoelectric conversion efficiency.

$$RMX_3 \qquad (1)$$

(R is a monovalent cation, M is a divalent metal cation, and X is a halogen anion.)

$$R^1R^2R^3_{n-1}M_nX_{3n+1} \qquad (2)$$

($R^1$, $R^2$ and $R^3$ are each independently a monovalent cation, M is a divalent metal cation, X is a halogen anion, and n is an integer of 1 to 10.)

The R is a monovalent cation, for example, a cation of the group 1 of the periodic table and includes an organic cation. Examples of the cation of the group 1 of the periodic table include $Li^+$, $Na^+$, $K^+$, and $Cs^+$. Examples of the organic cation include an ammonium ion which may have a substituent and a phosphonium ion which may have a substituent. There is no particular limitation on the substituent. Examples of the optionally substituted ammonium ion include an alkylammonium ion, a formamidinium ion and an arylammonium ion, and from the viewpoint of improving the photoelectric conversion efficiency, the optionally substituted ammonium ion is preferably one or more kinds selected from an alkyl ammonium ion and a formamidinium ion, more preferably one or more kinds selected from a monoalkylammonium ion and a formamidinium ion, still more preferably one or more kinds selected from a methylammonium ion, an ethylammonium ion, a butylammonium ion and a formamidinium ion, and even still more preferably a methylammonium ion.

Each of $R^1$, $R^2$, and $R^3$ mentioned above is independently a monovalent cation, and any or all of $R^1$, $R^2$, and $R^3$ may be the same. For example, examples of the monovalent cation include a cation of the group 1 of the periodic table and an organic cation. Examples of the cation of the group 1 of the periodic table include $Li^+$, $Na^+$, $K^+$, and $Cs^+$. Examples of the organic cation include an ammonium ion which may have a substituent and a phosphonium ion which may have a substituent. There is no particular restriction on the substituent. Examples of the optionally substituted ammonium ion include an alkylammonium ion, a formamidinium ion and an arylammonium ion, and from the viewpoint of improving the photoelectric conversion efficiency, the optionally substituted ammonium ion is preferably one or more kinds selected from an alkyl ammonium ion and a formamidinium ion, more preferably a monoalkylammonium ion, still more preferably one or more kinds selected from a methylammonium ion, an ethylammonium ion, a butylammonium ion, a hexylammonium ion, an octylammonium ion, a decylammonium ion, a dodecyl ammonium ion, a tetradecyl ammonium ion, a hexadecyl ammonium ion, and an octadecyl ammonium ion.

The n is an integer of 1 to 10 and from the viewpoint of improving the photoelectric conversion efficiency, n is preferably 1 to 4.

The M is a divalent metal cation and includes, for example, $Pb^{2+}$, $Sn^{2+}$, $Hg^{2+}$, $Cd^{2+}$, $Zn^{2+}$, $Mn^{2+}$, $Cu^{2+}$, $Ni^{2+}$, $Fe^{2+}$, $Co^{2+}$, $Pd^{2+}$, $Ge^{2+}$, $Y^{2+}$, and $Eu^{2+}$. From the viewpoint of excellent photoelectric conversion efficiency, the M is preferably $Pb^{2-}$, $Sn^{2+}$, or $Ge^{2+}$, more preferably $Pb^{2+}$ or $Sn^{2+}$, still more preferably $Pb^{2+}$.

The X is a halogen anion, and examples thereof include a fluorine anion, a chlorine anion, a bromine anion, and an iodine anion. In order to obtain a perovskite compound having a desired band gap energy, the X is preferably an iodine anion, a chlorine anion or a bromine anion, more preferably an iodine anion or a bromine anion, still more preferably a bromine anion.

The perovskite compound in the light absorption layer is not particularly limited as far as the compound is a compound having a perovskite type crystal structure. From the viewpoint of improving the photoelectric conversion efficiency, preferred is a perovskite compound having a band gap energy of 1.5 eV or more and 4.0 eV or less. The perovskite compound may be used alone, or two or more perovskite compounds different in band gap energy may be used.

From the viewpoint of improving the photoelectric conversion efficiency (voltage), the band gap energy of the perovskite compound is more preferably 1.7 eV or more, still more preferably 2.0 eV or more, even still more preferably 2.1 eV or more, even still more preferably 2.2 eV or more, and from the viewpoint of improving the photoelectric conversion efficiency (current), the band gap energy of the perovskite compound is more preferably 3.6 eV or less, still more preferably 3.0 eV or less, even still more preferably 2.4 eV or less. The band gap energies of the perovskite compound and the quantum dot containing the halogen element and the organic ligand can be determined from the absorption spectrum measured at 25°C by the method described in Examples described later. The wavelength corresponding to the band gap energy determined from the absorption spectrum is called an absorption edge wavelength.

Examples of the compound represented by the general formula (1) having a band gap energy of 1.5 eV or more and 4.0 eV or less include $CH_3NH_3PbCl_3$, $CH_3NH_3PbBr_3$, $CH_3NH_3PbI_3$, $CH_3NH_3PbBrI_2$, $CH_3NH_3PbBr_2I$, $CH_3NH_3SnCl_3$, $CH_3NH_3SnBr_3$, $CH_3NH_3SnI_3$, $CH(=NH)NH_3PbCl_3$, and $CH(=NH)NH_3PbBr_3$. Among these, from the viewpoint of improving the photoelectric conversion efficiency, $CH_3NH_3PbBr_3$ and $CH(=NH)NH_3PbBr_3$ are preferable and $CH_3NH_3PbBr_3$ is more preferable.

Examples of the compound represented by the general formula (2) having a band gap energy of 1.5 eV or more and 4.0 eV or less include $(C_4H_9NH_3)_2PbI_4$, $(C_6H_{13}NH_3)_2PbI_4$, $(C_8H_{17}NH_3)_2PbI_4$, $(C_{10}H_{21}NH_3)_2PbI_4$, $(C_{12}H_{25}NH_3)_2PbI_4$, $(C_4H_9NH_3)_2(CH_3NH_3)Pb_2I_7$, $(C_6H_{13}NH_3)_2(CH_3NH_3)Pb_2I_7$, $(C_8H_{17}NH_3)_2(CH_3NH_3)Pb_2I_7$, $(C_{10}H_{21}NH_3)_2(CH_3NH_3)Pb_2I_7$, $(C_{12}H_{25}NH_3)_2(CH_3NH_3)Pb_2I_7$, $(C_4H_9NH_3)_2(CH_3NH_3)_2Pb_3I_{10}$, $(C_6H_{13}NH_3)_2(CH_3NH_3)_2Pb_3I_{10}$, $(C_8H_{17}NH_3)_2(CH_3NH_3)_2Pb_3I_{10}$, $(C_{10}H_{21}NH_3)_2(CH_3NH_3)_2Pb_3I_{10}$, $(C_{12}H_{25}NH_3)_2(CH_3NH_3)_2Pb_3I_{10}$, $(C_4H_9NH_3)_2PbBr_4$, $(C_6H_{13}NH_3)_2PbBr_4$, $(C_8H_{17}NH_3)_2PbBr_4$, $(C_{10}H_{21}NH_3)_2PbBr_4$, $(C_4H_9NH_3)_2(CH_3NH_3)Pb_2Br_7$, $(C_6H_{13}NH_3)_2(CH_3NH_3)Pb_2Br_7$, $(C_8H_{17}NH_3)_2(CH_3NH_3)Pb_2Br_7$, $(C_{10}H_{21}NH_3)_2(CH_3NH_3)Pb_2Br_7$, $(C_{12}H_{25}NH_3)_2(CH_3NH_3)Pb_2Br_7$, $(C_4H_9NH_3)_2(CH_3NH_3)_2Pb_3Br_{10}$, $(C_6H_{13}NH_3)_2(CH_3NH_3)_2Pb_3Br_{10}$, $(C_8H_{17}NH_3)_2(CH_3NH_3)_2Pb_3Br_{10}$, $(C_{10}H_{21}NH_3)_2(CH_3NH_3)_2Pb_3Br_{10}$, $(C_{12}H_{25}NH_3)_2(CH_3NH_3)_2Pb_3Br_{10}$,

$(C_4H_9NH_3)_2(CH_3NH_3)_2Pb_3Cl_{10}$, $(C_6H_{13}NH_3)_2(CH_3NH_3)_2Pb_3Cl_{10}$, $(C_8H_{17}NH_3)_2(CH_3NH_3)_2Pb_3Cl_{10}$, $(C_{10}H_{21}NH_3)_2(CH_3NH_3)_2Pb_3Cl_{10}$, and $(C_{12}H_{25}NH_3)_2(CH_3NH_3)_2Pb_3Cl_{10}$.

The crystallite diameter of the perovskite compound of the light absorption layer is preferably 10 nm or more, more preferably 20 nm or more, still more preferably 40 nm or more, from the viewpoint of improving the photoelectric conversion efficiency and is preferably 1000 nm or less from the same viewpoint. The crystallite diameter of the light absorption layer in the range of 100 nm or less can be measured by the method described in Examples below. Further, the crystallite diameter in the range exceeding 100 nm cannot be measured by the method described in Examples described later but does not exceed the thickness of the light absorption layer.

The perovskite compound can be produced, for example, from a perovskite compound precursor as described later. As a precursor of the perovskite compound, for example, in the case where the perovskite compound is a compound represented by the general formula (1), a combination of a compound represented by $MX_2$ and a compound represented by RX can be mentioned. Also, in the case where the perovskite compound is a compound represented by the general formula (2), a combination of a compound represented by $MX_2$ with one or more kinds selected from a compound represented by $R^1X$, a compound represented by $R^2X$, and a compound represented by $R^3X$ can be mentioned.

The perovskite compound in the light absorption layer can be identified by the conventional methods such as element analysis, infrared (IR) spectrum, Raman spectrum, nuclear magnetic resonance (NMR) spectrum, X-ray diffraction pattern, absorption spectrum, emission spectrum, electron microscope observation, and electron beam diffraction.

The quantum dot containing the halogen element and the organic ligand is a quantum dot containing the halogen element and the organic ligand other than one or more components constituting a crystal structure of the quantum dot. A state of the halogen element and the organic ligand is not particularly limited, and is preferably a state of a compound in which the halogen element and the organic ligand are coordinated to the surface of the quantum dot (compound in which the halogen element and the organic ligand are coordinated to a metal element configured to constitute the quantum dot). Together with the halogen element and the organic ligand, a different ligand, which is other than the halogen element and the organic ligand, may be coordinated to the surface of the quantum dot. Hereinafter, unless otherwise specified, preferred embodiments of the quantum dot containing the halogen element and the organic ligand, except preferred embodiments of the organic ligand, are preferred embodiments common to the light absorption layer and its raw materials.

The quantum dot containing the halogen element and the organic ligand is, for example, a compound in which the halogen element and the organic ligand are coordinated to the surface of a metal oxide or a metal chalcogenide (such as sulfide, selenide, and telluride). From the viewpoint of improving the photoelectric conversion efficiency, preferred is a compound in which the halogen element and the organic ligand are coordinated to the surface of the metal chalcogenide. Examples of the metal chalcogenide include $PbS$, $PbSe$, $PbTe$, $CdS$, $CdSe$, $CdTe$, $Sb_2S_3$, $Bi_2S_3$, $Ag_2S$, $Ag_2Se$, $Ag_2Te$, $Au_2S$, $Au_2Se$, $Au_2Te$, $Cu_2S$, $Cu_2Se$, $Cu_2Te$, $Fe_2S$, $Fe_2Se$, $Fe_2Te$, $In_2S_3$, $SnS$, $SnSe$, $SnTe$, $CuInS_2$, $CuInSe_2$, $CuInTe_2$, $EuS$, $EuSe$, and $EuTe$. From the viewpoint of excellent photoelectric conversion efficiency, the quantum dot containing the halogen element and the organic ligand preferably contains Pb element, more preferably $PbS$ or $PbSe$, still more preferably $PbS$. In order to increase the interaction between the perovskite compound and the quantum dot, the metal constituting the perovskite compound and the metal constituting the quantum dot are preferably the same metal.

The halogen element is not particularly limited, and examples thereof include fluorine, chlorine, bromine, and iodine. The halogen element is preferably chlorine from the viewpoints of, for example, ease of production, dispersion stability, and cost of the quantum dot containing the halogen element and the organic ligand.

The atomic ratio of the halogen element to the metal element constituting the quantum dot containing the halogen element and the organic ligand is not particularly limited. The atomic ratio is preferably 0.1 or more, more preferably 0.2 or more, still more preferably 0.3 or more, and is preferably 1 or less, more preferably 0.8 or less, still more preferably 0.7 or less, from the viewpoint of improving the dispersibility of quantum dots in the light absorption layer or in the dispersion, as well as from the viewpoint of suppressing the carrier transfer from the perovskite compound to the quantum dot. In the light absorption layer, it is considered that the atomic ratio of the halogen element to the metal element constituting the quantum dot containing the halogen element and the organic ligand is almost the same as the atomic ratio of the halogen element to the metal element constituting the quantum dot in the quantum dot containing the halogen element and the organic ligand used as the raw material of the light absorption layer.

The organic ligand is not particularly limited. Examples of the organic ligand include a carboxyl group-containing compound, an amino group-containing compound, a thiol group-containing compound, and a phosphino group-containing compound.

Examples of the carboxyl group-containing compound include oleic acid, stearic acid, palmitic acid, myristic acid, lauric acid, capric acid, and the like.

Examples of the amino group-containing compound include oleylamine, stearylamine, palmitylamine, myristylamine, laurylamine, caprylamine, octylamine, hexylamine, butylamine and the like.

Examples of the thiol group-containing compound include ethanethiol, ethanedithiol, benzenethiol, benzenedithiol, decanethiol, decanedithiol, mercaptopropionic acid, and the like.

Examples of the phosphino group-containing compound include trioctylphosphine, tributylphosphine, and the like.

The organic ligand is preferably a carboxy group-containing compound or an amino group-containing compound, more preferably a carboxy group-containing compound, still more preferably a long chain fatty acid, even still more preferably oleic acid, from the viewpoints of ease of production, dispersion stability, versatility and cost of the quantum dot containing the halogen element and the organic ligand.

In the quantum dot containing the halogen element and the organic ligand used when the light absorption layer is produced, the molar ratio of the organic ligand to the metal element constituting the quantum dot is 0.01 or more, more preferably 0.05 or more, still more preferably 0.1 or more, even still more preferably 0.12 or more, from the viewpoints of promoting ligand exchange between the organic ligand and the precursor of the perovskite compound during production of the light absorption layer, and is 0.4 or less, more preferably 0.3 or less, still more preferably 0.2 or less, even still more preferably 0.15 or less, from the viewpoint of improving the dispersibility of the quantum dots in the light absorption layer or in the dispersion.

The molar ratio of the organic ligand contained in the quantum dot containing the halogen element and the organic ligand to the metal element constituting the perovskite compound in the light absorption layer is 0.001 or more, more preferably 0.005 or more, still more preferably 0.01 or more, and 0.1 or less, more preferably 0.05 or less, still more preferably 0.02 or less, from the viewpoint of improving the dispersibility of the quantum dots in the light absorption layer and exhibiting excellent performance.

The band gap energy of the quantum dot containing the halogen element and the organic ligand is not particularly limited. From the viewpoint of complementing the band gap energy which the perovskite compound does not have and improving the photoelectric conversion efficiency of the light absorption layer in the near-infrared light region, the band gap energy of the quantum dot containing the halogen element and the organic ligand is preferably 0.2 eV or more and equal to or less than the band gap energy of the perovskite compound. The quantum dot containing the halogen element and the organic ligand may be used singly or in combination of two or more kinds having different band gap energies. When two or more kinds of perovskite compounds having different band gap energies are used, "the band gap energy equal to or less than the band gap energy of the perovskite compound", which is the upper limit of the band gap energy of the quantum dot containing the halogen element and the organic ligand, means a band gap energy equal to or less than the maximum value of the band gap energy of two or more kinds of perovskite compounds. The band gap energy of the (halogen-element- and organic-ligand-containing) quantum dot can be determined from the absorption spectrum measured at 25°C by the method described in Examples described later.

From the viewpoint of improving the photoelectric conversion efficiency (voltage), the band gap energy of the quantum dot containing the halogen element and the organic ligand is more preferably 0.7 eV or more, still more preferably 0.8 eV or more, even still more preferably 0.9 eV or more, even still more preferably 1.0 eV or more, and from the viewpoint of improving the photoelectric conversion efficiency (current), the band gap energy of the quantum dot containing the halogen element and the organic ligand is more preferably 1.6 eV or less, still more preferably 1.4 eV or less, even still more preferably 1.2 eV or less, even still more preferably 1.1 eV or less.

The difference between the band gap energy of the perovskite compound and the band gap energy of the quantum dot containing the halogen element and the organic ligand is preferably 0.4 eV or more, more preferably 0.6 eV or more, still more preferably 0.8 eV or more, and preferably 2.0 eV or less, more preferably 1.5 eV or less, still more preferably 1.3 eV or less, from the viewpoint of improving the photoelectric conversion efficiency.

The particle size of the quantum dot containing the halogen element and the organic ligand in the light absorption layer, and that of the quantum dot containing the halogen element and the organic ligand that is a raw material of the light absorption layer are preferably 1 nm or more, more preferably 2 nm or more, still more preferably 3 nm or more from the viewpoint of improving stability and photoelectric conversion efficiency, and are preferably 20 nm or less, more preferably 10 nm or less, still more preferably 5 nm or less from the viewpoint of improving film formability and photoelectric conversion efficiency. The particle size of the quantum dot containing the halogen element and the organic ligand can be measured by a conventional method such as crystallite diameter analysis of XRD (X-ray diffraction) or transmission electron microscope observation.

Regarding the (halogen-element- and organic-ligand-containing) quantum dot, if the particle size and kind of quantum dots are determined by electron microscopic observation, electron beam diffraction, X-ray diffraction pattern, etc., it is also possible to calculate the band gap energy from the correlation between the particle size and the band gap energy (see, for example, ACS Nano 2014, 8, 6363-6371).

The method of coordinating the halogen element and the organic ligand to the surface of the quantum dot is not particularly limited. For example, nucleus formation and crystal growth for the quantum dot are allowed to occur in the presence of the halogen element ligand and the organic ligand to prepare the quantum dot in which the halogen element and the organic ligand are coordinated on the surface of the quantum dot. Specifically, a metal halide containing a metal element constituting the quantum dot is caused to react with an oxygen source or a chalcogen source to prepare a quantum dot which has a surface onto which the halogen element is coordinated. Thereafter, the prepared quantum dot in which the halogen element is coordinated, are caused to react with the organic ligand. This manner makes it possible to prepare the quantum dot which has a surface onto which the halogen element and the organic ligand are coordinated.

The (halogen-element- and organic-ligand-containing) quantum dots of the light absorption layer can be identified, for example, by element analysis, infrared (IR) spectrum, Raman spectrum, nuclear magnetic resonance (NMR) spectrum, X-ray diffraction pattern, absorption spectrum, emission spectrum, small angle X-ray scattering, electron microscopic observation, electron beam diffraction, and the like.

A method for verifying that the quantum dots contain the halogen element may be, for example, a method of using a photoelectron spectroscopy, such as ESCA (X-ray photoelectron spectroscopy), to detect the halogen element through elementary analysis of the quantum dot surface. Examples of a method for verifying that the quantum dots contain the organic ligand include a method of observing a change of a dispersibility of the quantum dots in an organic solvent, thermal analyses such as thermogravimetry-differential thermal analysis (TG-DTA), a nuclear magnetic resonance (NMR) method, and spectroscopies such as an infrared (IR) method. When the quantum dots contain no the halogen element as a component that partially constitutes the quantum dots, it is preferred to use a diffraction method, such as XRD (X-ray diffraction), to verify that the quantum dots belong to a crystal structure containing no the halogen element. In the meantime, when the quantum dots contain the halogen element as a component that partially constitutes the quantum dots, it is possible to use, for example, ESCA to distinguish between a crystal structure and the halogen element on the surface from a bonding energy peak shift of the halogen element.

A preferable combination of the perovskite compound and the quantum dot containing the halogen element and the organic ligand is preferably a combination of compounds containing the same metal element from the viewpoint of improving the photoelectric conversion efficiency, for example, a combination of $CH_3NH_3PbBr_3$ and PbS coordinated with the halogen element and the organic ligand, a combination of $CH_3NH_3PbBr_3$ and PbSe coordinated with the halogen element and the organic ligand, a combination of $CH_3NH_3PbI_3$ and PbS coordinated with the halogen element and the organic ligand, a combination of $CH(=NH)NH_3PbBr_3$ and PbS coordinated with the halogen element and the organic ligand, and a combination of $CH(=NH)NH_3PbBr_3$ and PbSe coordinated with the halogen element and the organic ligand, and more preferably a combination of $CH_3NH_3PbBr_3$ and PbS coordinated with the halogen element and the organic ligand.

The content ratio of the perovskite compound and the quantum dot containing the halogen element and the organic ligand in the light absorption layer is not particularly limited, but the content ratio of the quantum dot containing the halogen element and the organic ligand to the total content of the perovskite compound and the quantum dot containing the halogen element and the organic ligand is preferably 0.1% by mass or more, more preferably 1% by mass or more, still more preferably 2% by mass or more, even still more preferably 4% by mass or more, from the viewpoint of improving the photoelectric conversion efficiency, and preferably 10% by mass or less, more preferably 8% by mass or less, still more preferably 7% by mass or less, from the viewpoint of improving the film formability and photoelectric conversion efficiency.

The thickness of the light absorption layer is not particularly limited, but is preferably 30 nm or more, more preferably 50 nm or more, from the viewpoint of increasing light absorption to improve photoelectric conversion efficiency, and preferably 1000 nm or less, more preferably 800 nm or less, still more preferably 600 nm or less, even still more preferably 500 nm or less, from the same viewpoint. The thickness of the light absorption layer can be measured by a measuring method such as electron microscope observation of the cross section of the film.

From the viewpoint of improving the strength of a hole transport material (HTM) layer, the surface smoothness of the light absorption layer is preferably 30 nm or more, more preferably 50 nm or more, still more preferably 100 nm or more, and from the viewpoint of improving the photoelectric conversion efficiency, the surface smoothness of the light absorption layer is preferably 1000 nm or less, more preferably 500 nm or less, still more preferably 300 nm or less. The surface smoothness of the light absorption layer can be measured by the method described in the following Examples.

The coverage of the light absorption layer to the porous layer is preferably 10% or more, more preferably 20% or more, still more preferably 30% or more, even still more preferably 40% or more, from the viewpoint of improving the photoelectric conversion efficiency (current), and is 100% or less. The coverage of the light absorption layer to the porous layer can be measured by the method described in the following Examples.

From the viewpoint of improving the photoelectric conversion efficiency (voltage), the absorbance ratio (QD/P) of the (halogen-element- and organic-ligand-containing) quantum dot (QD) to the perovskite compound (P) in the light absorption layer is preferably 0.3 or less, more preferably 0.2 or less, still more preferably 0.1 or less, even still more preferably 0. The absorbance ratio (QD/P) in the light absorption layer is determined from the absorption spectrum of the light absorption layer measured by the method described in the following Example and is the ratio of the maximum absorbance of at least one kind of (halogen-element- and organic-ligand-containing) quantum dots to the absorbance of at least one kind of perovskite compounds. Here, the absorbance of at least one kind of (halogen-element- and organic-ligand-containing) quantum dot and the absorbance of at least one kind of perovskite compound are obtained respectively as the absorbance at the absorption peak position when they are measured independently.

From the viewpoint of improving photoelectric conversion efficiency (voltage), the light emission peak energy in the light absorption layer is preferably 0.2 eV or more, more preferably 0.4 eV or more, still more preferably 0.6 eV or more, even still more preferably 0.8 eV or more, when exciting the light absorption layer with light having a wavelength of 800 nm (energy 1.55 eV), and from the viewpoint of improving photoelectric conversion efficiency (current), the light emission peak energy in the light absorption layer is preferably 1.4 eV or less, more preferably 1.3 eV or less, still more preferably 1.2 eV or less, even still more preferably 1.1 eV or less.

From the viewpoint of improving photoelectric conversion efficiency, the difference between the light emission peak energy in the light absorption layer and the band gap energy of the perovskite compound is preferably 0.4 eV or more, more preferably 0.8 eV, still more preferably 1.0 eV or more, even still more preferably 1.2 eV or more, and preferably 3.4 eV or less, more preferably 2.5 eV or less, still more preferably 2.0 eV or less, even still more preferably 1.5 eV or less.

From the viewpoint of improving the photoelectric conversion efficiency, the difference between the light emission peak energy in the light absorption layer and the band gap energy of the (halogen-element- and organic-ligand-containing) quantum dot is preferably 0.5 eV or less, more preferably 0.2 eV or less, still more preferably 0.1 eV or less.

It is estimated that the difference (emission peak shift) between the emission peak energy in the dispersion of the (halogen-element- and organic-ligand-containing) quantum dots and the emission peak energy in the light absorption layer has a correlation with the distance between the particles of the (halogen-element- and organic-ligand-containing) quantum dots in the light absorption layer, that is, dispersibility and is preferably 0.5 eV or less, more preferably 0.2 eV or less, still more preferably 0.1 eV or less, from the viewpoint of improving the photoelectric conversion efficiency. In order to improve the dispersibility of the quantum dots containing the halogen element and the organic ligand in the light absorption layer, as described above, it is preferable to control the content of the halogen element and the organic ligand of the quantum dot, the particle size of the quantum dot, and the production method of the dispersion and the light absorption layer, within the preferred ranges.

Incidentally, as described in Examples below, the light emission peak energy in the light absorption layer can be determined as the peak wavelength (peak energy) of the emission spectrum when the light absorption layer is excited with light having a wavelength of 800 nm (energy 1.55 eV).

The light absorption layer contains the perovskite compound and the quantum dots containing the halogen element and the organic ligand, but preferably contains a complex formed of the perovskite compound and the quantum dots containing the halogen element and the organic ligand. By the complex formation, it is possible not only to make the quantum dots containing the halogen element and the organic ligand uniform in the crystal structure of the perovskite compound but also to make the interface structure between the perovskite compound and the quantum dot containing the halogen element and the organic ligand uniform at the atomic and molecular level, so that the effect of the present invention can be expected to be further improved. In order to form a complex by homogenizing the interface structure between the perovskite compound and the quantum dot containing the halogen element and the organic ligand at the atomic and molecular level, crystal lattice matching between the perovskite compound and the quantum dot is effective. For example, since $CH_3NH_3PbBr_3$ (5.92 Å) is close to PbS (5.97 Å) in the Pb-Pb atomic distance, a combination of $CH_3NH_3PbBr_3$ and PbS is preferable for forming the complex. By observation with a high-resolution transmission electron microscope (HRTEM) or the like, it can be confirmed whether the interface structure between the perovskite compound and the quantum dot is homogenized at the atomic or molecular level.

The method of forming a complex formed by the perovskite compound and the quantum dots containing the halogen element and the organic ligand is not particularly limited, but a method of mixing a precursor of the perovskite compound and a quantum dot containing the halogen element and the organic ligand in a dispersion and the like can be mentioned. The mixing method is not limited, but from the viewpoints of ease of production, cost, storage stability of the dispersion, improvement of photoelectric conversion efficiency, etc., the mixing temperature is preferably 0°C or more, more preferably 10°C or more, still more preferably 20°C or more, and preferably 50°C or less, more preferably 40°C or less, still more preferably 30°C or less. From the same viewpoint, the mixing time is preferably more than 0 hour, more preferably 0.1 hour or more, and preferably 72 hours or less, more preferably 24 hours or less, still more preferably 1 hour or less. From the above viewpoints, the mixing temperature is preferably 0°C or more and 50°C or less, more preferably 10°C or more and 40°C or less, still more preferably 20°C or more and 30°C or less, and the mixing time is preferably more than 0 hour and 72 hours or less, more preferably more than 0 hour and 24 hours or less, still more preferably 0.1 hours or more and 1 hour or less.

<Photoelectric Conversion Element>

The photoelectric conversion element of the present invention has the light absorption layer. In the photoelectric conversion element of the present invention, the configuration other than the light absorption layer is not particularly limited, and a configuration of a known photoelectric conversion element can be applied. In addition, the photoelectric conversion element of the present invention can be manufactured by a known method, except for the light absorption layer.

Hereinafter, the structure and manufacturing method of the photoelectric conversion element of the present invention will be described with reference to Fig. 1, but Fig. 1 is merely an example, and the present invention is not limited to the embodiment shown in Fig. 1.

Fig. 1 is a schematic sectional view showing an example of a structure of a photoelectric conversion element of the present invention. A photoelectric conversion element 1 has a structure in which a transparent substrate 2, a transparent conductive layer 3, a blocking layer 4, a porous layer 5, a light absorption layer 6, and a hole transport layer 7 are sequentially laminated. A transparent electrode substrate on the incident side of light 10 is composed of the transparent substrate 2 and the transparent conductive layer 3, and the transparent conductive layer 3 is bonded to an electrode (negative electrode) 9 which is a terminal for electrically connecting to an external circuit. In addition, the hole transport layer 7 is bonded to an electrode (positive electrode) 8 which serves as a terminal for electrically connecting to an external circuit.

As the material of the transparent substrate 2, any material may be used as long as it has strength, durability and light permeability, and synthetic resin and glass can be used for such a purpose. Examples of the synthetic resin include thermoplastic resins such as polyethylene naphthalate (PEN) film, polyethylene terephthalate (PET), polyester, polycarbonate, polyolefin, polyimide, and fluorine resin. From the viewpoints of strength, durability, cost and the like, it is preferable to use a glass substrate.

As the material of the transparent conductive layer 3, for example, indium-added tin oxide (ITO), fluorine-added tin oxide (FTO), tin oxide ($SnO_2$), indium zinc oxide (IZO), zinc oxide (ZnO), a polymer material having high conductivity and the like can be mentioned. Examples of the polymer material include polyacetylene type polymer materials, polypyrrole type polymer materials, polythiophene type polymer materials, and polyphenylenevinylene type polymer materials. As the material of the transparent conductive layer 3, a carbon-based thin film having high conductivity can also be used. Examples of a method for forming the transparent conductive layer 3 include a sputtering method, a vapor deposition method, a method of coating a dispersion, and the like.

Examples of the material of the blocking layer 4 include titanium oxide, aluminum oxide, silicon oxide, niobium oxide, tungsten oxide, tin oxide, zinc oxide, and the like. Examples of a method for forming the blocking layer 4 include a method of directly sputtering the above material on the transparent conductive layer 3 and a spray pyrolysis method. In addition, there is a method wherein a solution in which the above material is dissolved in a solvent or a solution in which a metal hydroxide that is a precursor of a metal oxide is dissolved is coated on the transparent conductive layer 3, dried, and baked as necessary. Examples of the coating method include gravure coating, bar coating, printing, spraying, spin coating, dipping, die coating, and the like.

The porous layer 5 is a layer having a function of supporting the light absorption layer 6 on its surface. In order to increase the light absorption efficiency in the solar cell, it is preferable to increase the surface area of the portion receiving light. By providing the porous layer 5, it is possible to increase the surface area of such a light-receiving portion.

Examples of the material of the porous layer 5 include a metal oxide, a metal chalcogenide (for example, a sulfide and a selenide), a compound having a perovskite type crystal structure (excluding the light absorber described above), a silicon oxide (for example, silicon dioxide and zeolite), and carbon nanotubes (including carbon nanowires and carbon nanorods), and the like.

Examples of the metal oxide include oxides of titanium, tin, zinc, tungsten, zirconium, hafnium, strontium, indium, cerium, yttrium, lanthanum, vanadium, niobium, aluminum, tantalum, and the like, and examples of the metal chalcogenide include zinc sulfide, zinc selenide, cadmium sulfide, cadmium selenide, and the like.

Examples of the compound having a perovskite type crystal structure include strontium titanate, calcium titanate, barium titanate, lead titanate, barium zirconate, barium stannate, lead zirconate, strontium zirconate, strontium tantalate, potassium niobate, bismuth ferrate, barium strontium titanate, barium lanthanum titanate, calcium titanate, sodium titanate, bismuth titanate, and the like.

The material for forming the porous layer 5 is preferably used as fine particles, more preferably as a dispersion containing fine particles. Examples of a method for forming the porous layer 5 include a wet method, a dry method, and other methods (for example, methods described in Chemical Review, Vol. 110, page 6595 (2010)). In these methods, it is preferable to coating the surface of the blocking layer 4 with a dispersion (paste), followed by baking. By baking, the fine particles can be brought into close contact with each other. Examples of coating methods include gravure coating method, bar coating method, printing method, spraying method, spin coating method, dipping method, die coating method, and the like.

The light absorption layer 6 is the above-described Light absorption layer of the present invention. A method of forming the light absorption layer 6 is not particularly limited, and, for example, there is preferably mentioned a method based on a so-called wet process in which a dispersion containing the perovskite compound or its precursor and the quantum dots containing the halogen element and the organic ligand is prepared and the prepared dispersion is coated on the surface of the porous layer 5, and is dried.

In the wet process, the dispersion containing the perovskite compound or its precursor and the quantum dots containing the halogen element and the organic ligand preferably contains a solvent in view of film-forming property, cost, storage stability, and excellent performance (for example, photoelectric conversion property). Examples of the solvent include esters (methyl formate, ethyl formate, etc.), ketones ($\gamma$-butyrolactone, N-methyl-2-pyrrolidone, acetone, dimethyl ketone, diisobutyl ketone, etc.), ethers (diethyl ether, methyl tert-butyl ether, dimethoxymethane, 1,4-dioxane, tetrahydrofuran, etc.), alcohols (methanol, ethanol, 2-propanol, tert-butanol, methoxypropanol, diacetone alcohol, cyclohexanol, 2-fluoroethanol, 2,2,2-trifluoroethanol, 2,2,3,3-tetrafluoro-1-propanol, etc.), glycol ethers (cellosolves), amide type solvents (N,N-dimethylformamide, acetamide, N,N-dimethylacetamide, etc.), nitrile type solvents (acetonitrile, isobutyronitrile, propionitrile, methoxyacetonitrile etc.), carbonate type solvents (ethylene carbonate, propylene carbonate, etc.), halogenated hydrocarbons (methylene chloride, dichloromethane, chloroform, etc.), hydrocarbons, dimethylsulfoxide, and the like.

The solvent of the dispersion is preferably a polar solvent, more preferably at least one solvent selected from ketones, amide type solvents, and dimethylsulfoxide (DMSO), still more preferably an amide type solvent, even still more preferably N,N-dimethylformamide from the viewpoints of film forming properties, cost, storage stability, and expression of excellent performance (for example, photoelectric conversion characteristics).

In view of film-forming property, cost, storage stability, and expression of excellent performance (for example, photoelectric conversion characteristics), the metal concentration of the perovskite compound or its precursor in the dispersion is preferably 0.1 mol/L or more, more preferably 0.2 mol/L or more, still more preferably 0.3 mol/L or more, and preferably 1.5 mol/L or less, more preferably 1.0 mol/L or less, still more preferably 0.5 mol/L or less.

From the viewpoints of film-forming property, cost, storage stability, and expression of excellent performance (for example, photoelectric conversion characteristics), the solid content concentration of the quantum dots containing the halogen element and the organic ligand in the dispersion is preferably 1 mg/mL or more, more preferably 5 mg/mL or more, still more preferably 10 mg/mL or more, and preferably 100 mg/mL or less, more preferably 50 mg/mL or less, still more preferably 30 mg/mL or less.

The preparation method of the dispersion is not particularly limited. The specific preparation method is as described in Examples.

The coating method in the wet process is not particularly limited, and examples thereof include gravure coating method, bar coating method, printing method, spraying method, spin coating method, dipping method, die coating method, and the like.

As a drying method in the wet process, for example, a thermal drying method, an air stream drying method, a vacuum drying method and the like can be mentioned, from the viewpoints of ease of production, cost, and expression of excellent performance (for example, photoelectric conversion characteristics), and the thermal drying is preferable.

As a more detailed method of forming the light absorption layer 6 containing the perovskite compound and the quantum dots containing the halogen element and the organic ligand, for example, the following forming method is preferable. The specific forming method is as described in Examples.

First, a dispersion containing the quantum dots in which the halogen element and the organic ligand are coordinated is prepared.

A method for coordinating the halogen element and the organic ligand on the quantum dot surface is as described above.

Next, a solution containing a precursor of the perovskite compound is prepared. As the solvent, for example, N,N-dimethylformamide, dimethyl sulfoxide, $\gamma$-butyrolactone and the like can be mentioned.

Thereafter, the dispersion containing the quantum dots coordinated with the halogen element and the organic ligand and the solution containing the precursor of the perovskite compound are mixed to exchange the ligand of the quantum dot with the precursor of the perovskite compound, thereby to prepare a dispersion containing quantum dots in which the precursor of the perovskite compound is coordinated. Note that it is preferable that the dispersion medium of the dispersion containing the quantum dots coordinated with the halogen element and the organic ligand is not miscible with the solvent of the solution containing the precursor of the perovskite compound. Thereby, it is possible to phase-separate the solution containing the separated ligand and the dispersion containing the quantum dot coordinated with the precursor of the perovskite compound. Thus, a dispersion containing the quantum dots in which the precursor of the perovskite compound is coordinated can be extracted. The dispersion medium for the dispersion and the solvent for the solution may be selected for use from the solvents which are immiscible with each other.

In the above-mentioned ligand exchange, the ligand-removing rate of the organic ligand is preferably 10% or more, more preferably 15% or more, still more preferably 20% or more, from the viewpoint of improving the dispersibility of the quantum dots in the light absorption layer or in the dispersion.

The dispersion containing quantum dots in which the prepared precursor of the perovskite compound is coordinated is coated to the surface of the porous layer 5 and dried to form the light absorption layer 6. Examples of the coating method include a gravure coating method, a bar coating method, a printing method, a spray method, a spin coating method, a dipping method, a die coating method, and the like.

As a material of the hole transport layer 7, there can be mentioned, for example, a carbazole derivative, a polyarylalkane derivative, a phenylenediamine derivative, an arylamine derivative, an amino-substituted chalcone derivative, a styrylanthracene derivative, a fluorene derivative, a hydrazone derivative, a stilbene derivative, a silazane derivative, an aromatic tertiary amine compound, a styrylamine compound, an aromatic dimethylidine-based compound, a porphyrin-based compound, a phthalocyanine-based compound, a polythiophene derivative, a polypyrrole derivative, a polyparaphenylene vinylene derivative, and the like. Examples of a method for forming the hole transport layer 7 include a coating method, a vacuum vapor deposition method and the like. Examples of the coating method include a gravure coating method, a bar coating method, a printing method, a spray method, a spin coating method, a dipping method, a die coating method, and the like.

As the material of the electrode (positive electrode) 8 and the electrode (negative electrode) 9, there can be mentioned, for example, metals such as aluminum, gold, silver and platinum; conductive metal oxides such as indium tin oxide (ITO), indium zinc oxide (IZO), and zinc oxide (ZnO); organic conductive materials such as conductive polymers; and carbon-based materials such as nanotubes. Examples of a method for forming the electrode (positive electrode) 8 and the electrode (negative electrode) 9 include a vacuum vapor deposition method, a sputtering method, a coating method, and the like.

<Solar Cell>

The solar cell of the present invention has the photoelectric conversion element. In the solar cell of the present invention, the configuration other than the light absorption layer is not particularly limited, and a known solar cell configuration can be applied.

EXAMPLES

Hereinafter, the present invention will be described specifically based on Examples. Unless otherwise indicated in the table, the content of each component is % by mass. In addition, the evaluation/measurement method are as follows. In addition, unless otherwise noted, the measurement was carried out at 25°C.

<I-V Curve>

Using an I-V characteristic measuring device (PECK 2400-N, manufactured by Peccell Technologies, Inc.) with a xenon-lamp white light as a light source (PEC-L01, manufactured by Peccell Technologies, Inc.) at a light intensity (100 mW/cm$^2$) equivalent to sunlight (AM 1.5) under a mask of light irradiation area 0.0363 cm$^2$ (2 mm square), an I-V curve of the cell was measured under the conditions of a scanning speed of 0.1 V/sec (0.01 V step), a waiting time of 50 msec after voltage setting, a measurement integration time of 50 msec, a starting voltage of -0.1 V, and an ending voltage of 1.1 V. The light intensity was corrected with a silicon reference (BS-520, 0.5714 mA). The short-circuit current density (mA/cm$^2$), open circuit voltage (V), fill factor (FF), and conversion efficiency (%) were determined from the I-V curve.

<IPCE (Incident Photon-to-Current (Conversion) Efficiency)>

IPCE (wavelength dependence of external conversion efficiency with respect to incident light) was measured using a spectral response measurement system (CEP-2000 MLR, manufactured by Bunkoukeiki Co., Ltd.) under a mask of a light irradiation area of 0.0363 cm$^2$ in a wavelength range of 300 to 1200 nm. External quantum efficiencies at wavelengths of 500 nm and 900 nm were determined.

<Absorption Spectrum>

Using a UV-Vis spectrophotometer (SolidSpec-3700, manufactured by Shimadzu Corporation) under the conditions of a scanning speed of medium speed, a sample pitch of 1 nm, a slit width of 20, and an integrating sphere detector unit, the absorption spectrum of the light absorption layer was measured in the range of 300 to 1600 nm on a sample before applying the hole transport material. Background measurement was carried out with a fluorine-doped tin oxide (FTO) substrate (manufactured by Asahi Glass Fabritec Co., Ltd., 25 × 25 × 1.8 mm).

The absorption spectrum of the PbS quantum dot dispersion was similarly measured in a hexane dispersion having a concentration of 0.1 mg/mL of PbS quantum dot powder using a 1 cm square quartz cell.

Note that the absorption spectrum of the horizontal axis representing the wavelength λ and the vertical axis representing the absorbance A was converted into the spectrum of the horizontal axis representing the energy hv and the vertical axis representing $(\alpha h\nu)^{1/2}$ ($\alpha$; absorption coefficient), and a straight line was fitted to the rising part of absorption and the intersection of the straight line and the baseline was taken as the band gap energy.

<Emission Spectrum>

Using a near-infrared fluorescence spectrometer (Fluorolog, manufactured by Horiba, Ltd.), the emission spectrum of the light absorption layer was measured in the range of 850 to 1550 nm on a sample before applying a hole transport material, under the conditions of an excitation wavelength of 800 nm (Example 1, Comparative Example 1) or an excitation wavelength of 815 nm (Example 2, Comparative Example 2), an excitation light slit-width of 10 nm, an emission slit width of 15 nm, an acquisition time of 0.1 sec, an average of two times integrations, and dark offset on.
The emission spectrum of the PbS quantum dot dispersion was similarly measured using a 1 cm square tetrahedral transparent cell in a hexane dispersion having a concentration of 0.1 mg/mL of PbS quantum dot powder.

<Surface Smoothness of Light Absorption Layer>

With respect to the surface smoothness of the light absorption layer, Ry (Rmax) after automatic tilt correction was measured at 5 points in a sample before applying a hole transport material, using a nanoscale hybrid microscope (AFM "VN-8010", manufactured by KEYENCE CORPORATION) in a DFM-H mode in a measurement range of 100 $\mu$m × 75 $\mu$m, and then the average value was determined.

<Coverage of Light Absorption Layer>

The coverage of the light absorption layer was calculated from the area ratio (area rate) of the light absorption layer to the whole area by measuring the SEM photograph (enlargement magnification: 20000 times) of the surface of the light absorption layer on a sample before applying a hole transport material, using a field emission high-resolution scanning electron microscope (FE-SEM "S-4800", manufactured by Hitachi, Ltd.), and by specifying the light absorption layer with a pen tool from the SEM photograph with use of an image analysis software (Winroof).

<X-Ray Diffraction Analysis>

The crystallite diameter of the perovskite compound of the light absorption layer was determined in the range of 5 to 60° on a sample before applying a hole transport material by using a powder X-ray diffractometer (MiniFlex 600, light source Cu K$\alpha$, tube voltage 40 kV, tube current 15 mA, manufactured by Rigaku Corporation) under the conditions of a sampling width of 0.02°, a scanning speed of 20°/min, a solar slit (incident) of 5.0°, a divergence slit of 1.250°, a vertical divergence of 13.0 mm, a scattering slit of 13.0 mm, a solar slit (reflection) of 5.0°, and a receiving slit of 13.0 mm. The crystallite diameter of the perovskite compound was calculated at the strongest peak of the perovskite compound using an analysis software (PDXL, ver. 2.6.1.2).
The crystallite diameter (particle size) of the PbS quantum dot was measured similarly in a PbS quantum dot powder on a glass holder and calculated at the cubic (220) peak (2$\theta$=42°) of PbS using an analysis software (PDXL, ver. 2.6.1.2).

<Composition of PbS Quantum Dot Powder>

The Pb concentration in the PbS quantum dot powder was quantified by high frequency inductively coupled plasma-atomic emission spectroscopy (ICP) after completely dissolving the PbS quantum dot powder in a mixed solution of nitric acid and hydrogen peroxide.
The concentration of oleate anion in the PbS quantum dot powder was quantified by a proton ($^1$H) nuclear magnetic resonance (NMR) method using dibromomethane (manufactured by Wako Pure Chemical Industries, Ltd.) as an internal standard substance in a deuterated toluene (containing 99 atom% D, and TMS 0.03 vol%, manufactured by Sigma-Aldrich Japan K.K.). The measurement was carried out using an NMR apparatus (VNMRS 400 manufactured by Agilent Company) under the conditions of a resonance frequency of 400 MHz, a delay time of 60 seconds, and a 32 times-integration, and the concentration of oleate anion in the PbS quantum dot powder was determined from the ratio of the integral value of the vinyl proton (5.5 ppm vs. TMS) of the oleate anion to the integral value of dibromomethane (3.9 ppm vs. TMS).
The Cl concentration in the PbS quantum dot powder was quantified by photoelectron spectroscopy (ESCA) in a PbS quantum dot powder on a glass substrate. Using an ESCA device (PHI Quantera SXM, manufactured by Ulvac-Phi, Inc.), ESCA measurement was carried out under the conditions of a monochromatic Al K$\alpha$ X-ray source (25 W, 15 kV), a beam diameter of 100 $\mu$m, a measurement range of 1 mm$^2$, a pass energy of 112 eV, a step of 0.2 eV, a charge correction neutralizer and an Ar$^+$ irradiation, a photoelectron take-off angle of 45°, and a binding energy correction C1s (284.8 eV), and the composition was determined from the peaks of Pb4f, S2p, and C12p.

<Removal Rate of oleate anion>

The removal rate of oleate anion at the time of ligand exchange from the oleate anion of the PbS quantum dot to the perovskite raw material was determined by quantitatively determining the oleic acid concentration in the upper phase hexane solution at the ligand exchange by an NMR method, and the molar ratio of the amount of oleic acid in the hexane solution to the amount of oleate anion of the PbS quantum dot before the ligand exchange was calculated.

$$\text{oleate anion removal rate (\%)} = 100 \times \text{Amount of oleic}$$
$$\text{acid in upper phase hexane solution/Amount of oleate anion}$$
$$\text{in PbS quantum dot before ligand exchange}$$

<Molar Ratio of oleate anion to Pb Element Constituting PbS Quantum Dot in Light Absorption Layer>

The molar ratio of the oleate anion to the Pb element constituting the PbS quantum dot in the light absorption layer was calculated from the amount of the oleate anion in the PbS quantum dot before ligand exchange and the oleate anion removal rate.

$$\text{Molar ratio of oleate anion to Pb element}$$
$$\text{constituting PbS quantum dot in light absorption layer} = (1$$
$$- \text{oleate anion removal ratio/100}) \times (\text{Molar ratio of oleate}$$
$$\text{anion/Pb in PbS quantum dot before ligand exchange})$$

<Molar Ratio of oleate anion to Pb Element Constituting Perovskite in Light Absorption Layer>

The molar ratio of the oleate anion to the Pb element constituting the perovskite in the light absorption layer was calculated from the amount of oleate anion of the PbS quantum dot before ligand exchange, the oleate anion removal rate, and the blend composition (the molar ratio of the Pb element constituting the PbS quantum dot to the Pb element constituting the perovskite).

$$\text{Molar ratio of oleate anion to Pb element}$$
$$\text{constituting perovskite in light absorption layer} = (1 -$$
$$\text{oleate anion removal rate/100}) \times (\text{Molar ratio of oleate}$$
$$\text{anion/Pb in PbS quantum dot before ligand exchange}) \times$$
$$(\text{Molar ratio of Pb in PbS quantum dot/Pb in perovskite})$$

<Production of PbS Quantum Dot Containing Cl Element and oleate anion>

Into a 300 mL three-necked flask were placed 8.34 g of lead chloride (99.999%, manufactured by Alfa Aesar) and 64.8 g of oleylamine (C18: 80% or more, manufactured by Acros Organics), and after evacuating the inside of the reaction system at 80°C using a diaphragm type vacuum pump and purging with nitrogen gas, the mixture was stirred at 140°C for 30 minutes and then cooled to 30°C to prepare a Pb-source white turbid solution. On the other hand, 0.321 g of sulfur crystal (99.999%, manufactured by Wako Pure Chemical Industries, Ltd.) was dissolved in 8.10 g of oleylamine at 120°C and then cooled to 80°C to prepare an S source solution. Under a nitrogen gas atmosphere and vigorously stirring, the S source solution was injected into the Pb source white turbid solution (30°C) using a syringe over 10 seconds to produce PbS quantum dots (black turbid liquid) containing Cl element and oleylamine. Further, after stirring for 40 seconds, 200 mL of cold hexane was added to stop crystal growth of the PbS quantum dots. After removal of the gray precipitate (lead chloride) by centrifugation (CR21 GIII, R12A rotor, 4000 rpm, 3 minutes, manufactured by Hitachi Koki Co., Ltd.), the same amount of ethanol was added to the black supernatant to obtain a black precipitate. The black precipitate (4 g) which had been dried under reduced pressure was redispersed in 100 g of hexane, and after removing the gray precipitate (lead chloride) by centrifugation, 10 g of oleic acid (90%, manufactured by Sigma-Aldrich Japan K.K.) was added to the black supernatant, then the mixture was allowed to stand for 18 hours. Further, after removal of the gray precipitate (lead chloride) by centrifugation, the same amount of ethanol was added to the black supernatant to obtain a black precipitate. After vacuum filtration (pore size: 0.2 μm, material: PTFE) and ethanol washing, the black filtrate was dried under reduced pressure to produce a PbS quantum dot powder in which Cl element and oleate anion were coordinated.

It was found that the Pb/S/Cl atomic ratio was 1/1.2/0.65 from the ESCA analysis result, the molar ratio of oleate anion/Pb was 0.13 from NMR and ICP analysis results, the crystallite diameter was 3.6 nm from the X-ray diffraction result, the absorption edge wavelength was 1240 nm from the absorption spectrum, and the emission peak wavelength was 1260 nm from the emission spectrum.

<Production of PbS Quantum Dot Containing No Cl Element>

Into 5 g of PbS core-type quantum dots (manufactured by Sigma-Aldrich Japan Co. LLC.; oleic acid coat; fluorescent wavelength: 1000 nm; concentration in toluene: 10 mg/mL) was mixed with the same amount of acetone (manufactured by Wako Pure Chemical Industries, Ltd.), and the mixture was subjected to centrifugal separation (CR21 GIII, R3S rotor, 2500 rpm, 60 minutes, manufactured by Hitachi Koki Co., Ltd.) to remove the supernatant. The resultant black precipitation was then dried under reduced pressure to produce a PbS quantum dot powder containing no Cl element.

It was found that the Pb/S/Cl atomic ratio was 1/1.1/0 from the ESCA analysis result, the molar ratio of oleate anion/Pb was 0.62 from NMR and ICP analysis results, the crystallite diameter was 3.0 nm from the X-ray diffraction result, the absorption edge wavelength was 1050 nm from the absorption spectrum, and the emission peak wavelength was 1050 nm from the emission spectrum.

<Example 1>

The following steps (1) to (7) were carried out sequentially to prepare a cell.

(1) Etching and Cleaning of FTO Substrate

A part of a glass substrate with 25 mm square fluorine doped tin oxide (FTO) (manufactured by Asahi Glass Fabritec Corporation, 25 × 25 × 1.8 mm, hereinafter referred to as FTO substrate) was etched with Zn powder and a 2 mol/L hydrochloric acid aqueous solution. Ultrasonic cleaning was carried out for 10 minutes sequentially with 1 mass% neutral detergent, acetone, 2-propanol (IPA), and ion exchanged water.

(2) Ozone Cleaning

Ozone cleaning of the FTO substrate was performed immediately before the compact $TiO_2$ layer forming step. With the FTO side facing up, the substrate was placed in an ozone generator (ozone cleaner PC-450 UV, manufactured by Meiwafosis Co., Ltd.) and irradiated with UV for 30 minutes.

(3) Formation of Compact $TiO_2$ Layer (Blocking Layer)

Bis(2,4-pentanedionato)bis(2-propanolato) titanium (IV) (4.04 g, 75% IPA solution, manufactured by Tokyo Chemical Industry Co., Ltd.) was dissolved in 123.24 g of ethanol (anhydrous, manufactured by Wako Pure Chemical Industries) to prepare a spray solution. The spray solution was sprayed at a pressure of 0.3 MPa to an FTO substrate on a hot plate (450°C) from a height of about 30 cm. Spraying was repeated twice on the substrates of 20 cm × 8 rows to a spraying amount of about 7 g, and then the sprayed substrate was dried at 450°C for 3 minutes. This operation was repeated twice more to spray a total of about 21 g of the spray solution. Thereafter, the FTO substrate was immersed in an aqueous solution (50 mM) of titanium chloride (manufactured by Wako Pure Chemical Industries, Ltd.) and heated at 70°C for 30 minutes. After washing with water and drying, the FTO substrate was calcined at 500°C for 20 minutes (temperature rising: 15 minutes) to form a compact $TiO_2$ ($cTiO_2$) layer.

(4) Formation of Mesoporous TiO$_2$ Layer (Porous Layer)

Ethanol (1.41 g, anhydrous, manufactured by Wako Pure Chemical Industries, Ltd.) was added to 0.404 g of an anatase form TiO$_2$ paste (PST-18NR, manufactured by JGC Catalysts and Chemicals Ltd.) and the mixture was subjected to ultrasonic dispersion for 1 hour to obtain a TiO$_2$ coating liquid. In a dry room, the TiO$_2$ coating liquid was spin-coated (5000 rpm × 30 sec) on the cTiO$_2$ layer using a spin coater (MS-100, manufactured by Mikasa Co., Ltd.). After drying for 30 minutes on a hot plate at 125°C, the cTiO$_2$ layer was calcined at 500°C for 30 minutes (time for temperature rising: 60 minutes) to form a mesoporous TiO$_2$ (mTiO$_2$) layer.

(5) Formation of Light Absorption Layer

The light absorption layer and the hole transport layer were formed in a glove box. Lead bromide (PbBr$_2$, a precursor for perovskite, 0.114 g, manufactured by Tokyo Chemical Industry Co., Ltd.), 0.035 g of methylamine hydro-bromide (CH$_3$NH$_3$Br, manufactured by Tokyo Chemical Industry Co., Ltd.), and 1 mL of anhydrous N,N-dimethylformamide (anhydrous DMF, manufactured by Wako Pure Chemical Industries, Ltd.) were mixed and stirred at room temperature to prepare a DMF solution (colorless transparent) of 0.31 M bromine-based perovskite (CH$_3$NH$_3$PbBr$_3$) raw material. Under stirring at room temperature (25°C), 1 mL of the DMF solution of the bromine-based perovskite raw material was added to 2 mL of a hexane dispersion (PbS quantum dot powder 10 mg/mL in hexane) containing PbS quantum dots to which Cl element and oleate anion were coordinated, and the mixture was stirred for 10 minutes, then allowed to stand for 1 hour. After removal of the colorless transparent hexane solution of the upper phase, a dispersion (containing PbS in a mass ratio of 6.3% with respect to the total content of PbS and perovskite) of the lower phase containing PbS quantum dots in which the bromine-based perovskite raw material was coordinated was filtered through a PTFE filter having a pore size of 0.45 μm. The dispersion was spin-coated at 5000 rpm for 30 seconds on the mTiO$_2$ layer using a spin coater (MS-100 manufactured by Mikasa Co., Ltd.). After 20 seconds from the start of spinning, 1 mL of toluene (anhydrous, manufactured by Wako Pure Chemical Industries, Ltd.) as a poor solvent was added dropwise at once to the center portion of the spin. Immediately after spin coating, the spin-coated product was dried on a 100°C hot plate for 10 minutes. After the contacting portion with the FTO was wiped off with a cotton swab impregnated with DMF, drying at 70°C for 60 minutes was performed to form a light absorption layer. The light absorption layer includes bromine-based perovskite compound CH$_3$NH$_3$PbBr$_3$ and PbS quantum dots containing Cl element and oleate anion. The production of the perovskite compound was confirmed by X-ray diffraction pattern, absorption spectrum, and electron microscope observation, and the formation of the quantum dots was also confirmed from the fluorescence spectrum.

(6) Formation of Hole Transport Layer

Bis(trifluoromethanesulfonyl)imide lithium (LiTFSI, 9.1 mg, manufactured by Wako Pure Chemical Industries, Ltd.), 8.7 mg of [tris(2-(1H-pyrazol-1-yl)-4-tert-butylpyridine) cobalt(III) tris(bis(trifluoromethylsulfonyl)imide)] (Co(4-tButylpyridyl-2-1H-pyrazole) 3.3 TFSI, manufactured by Wako Pure Chemical Industries, Ltd.), 72.3 mg of 2,2',7,7'-tetrakis[N,N-di-p-methoxyphenylamino]-9,9'-spirobifluorene (Spiro-OMeTAD, manufactured by Wako Pure Chemical Industries, Ltd.), 1 mL of chlorobenzene (manufactured by Nacalai Tesque), and 28.8 μL of tributylphosphine (TBP, manufactured by Sigma-Aldrich) were mixed and stirred at room temperature to prepare a hole transport material (HTM) solution (black-purple transparent). Immediately before use, the HTM solution was filtered through a PTFE filter with a pore size of 0.45 μm. The HTM solution was spin-coated (4000 rpm × 30 sec) on the light absorption layer using a spin coater (MS-100, manufactured by Mikasa Co., Ltd.). Immediately after spin coating, the spin-coated product was dried on a 70°C hot plate for 30 minutes. After drying, the contact part with FTO was wiped off with a cotton swab impregnated with chlorobenzene, then the entire back surface of the substrate was wiped off with a cotton swab impregnated with DMF, further drying was performed on a hot plate at 70°C for several minutes, thereby forming a hole transport layer.

(7) Deposition of Gold Electrode

Gold was deposited to a thickness of 100 nm on the hole transport layer (vacuum deposition rate: 8 to 9 Å/sec) under vacuum (4 to 5 × 10$^{-3}$ Pa) using a vacuum vapor deposition apparatus (VTR-060M/ERH, manufactured by ULVAC KIKO Inc.) to form a gold electrode.

<Example 2>

A light absorption layer was formed and then a cell was produced in the same way as in Example 1 except that in item (5) Formation of Light Absorption Layer in Example 1, instead of lead bromide, 0.143 g of lead iodide (PbI$_2$, a precursor for perovskite, manufactured by Tokyo Chemical Industry Co., Ltd.), and instead of methylamine hydrobromide, 0.049 g of methylamine hydroiodide (CH$_3$NH$_3$I, manufactured by Tokyo Chemical Industry Co., Ltd.) was used.

<Comparative Example 1>

A light absorption layer was formed and then a cell was produced in the same way as in Example 1 except that in item (5) Formation of Light Absorption Layer in Example 1, instead of PbS quantum dots containing Cl element and oleate anion, PbS quantum dots containing no Cl element were used.

<Comparative Example 2>

A light absorption layer was formed and then a cell was produced in the same way as in Example 2 except that in item (5) Formation of Light Absorption Layer in Example 2, instead of PbS quantum dots containing Cl element and oleate anion, PbS quantum dots containing no Cl element were used.

[Table 1]

| | | Example 1 | Example 2 | Comparative Example 1 | Comparative Example 2 |
|---|---|---|---|---|---|
| Perovskite (P) | Compound | CH$_3$NH$_3$PbBr$_3$ | CH$_3$NH$_3$PbI$_3$ | CH$_3$NH$_3$PbBr$_3$ | CH$_3$NH$_3$PbI$_3$ |
| | Band gap energy (eV) | 2.3 | 1.6 | 2.3 | 1.6 |
| Quantum dot (QD) | Compound | PbS | PbS | PbS | PbS |
| | Cl/Pb (atomic ratio) | 0.65 | 0.65 | 0 | 0 |
| | oleate anion/Pb (molar ratio) | 0.13 | 0.13 | 0.62 | 0.62 |
| | Particle size (nm) | 3.6 | 3.6 | 3.0 | 3.0 |
| | Band gap energy (eV) | 1.0 | 1.0 | 1.2 | 1.2 |
| | Emission peak energy in (eV) liquid | 0.98 | 0.98 | 1.2 | 1.2 |
| | PbS-converted blend amount (% by mass) | 6.3 | 5.0 | 7.1 | 5.6 |
| Ligand exchange | Removal rate of oleate (%) anion | 24 | 28 | 24 | 28 |
| Cell properties | Short-circuit current (mA/cm$^2$) density | 1.26 | 0.97 | 0.74 | 0.85 |
| | Open-circuit voltage (V) | 0.49 | 0.65 | 0.40 | 0.56 |
| | Fill factor | 0.60 | 0.62 | 0.66 | 0.42 |
| | Conversion efficiency (%) | 0.37 | 0.39 | 0.19 | 0.20 |
| | External quantum (%) efficiency at 500 nm | 17 | 9.9 | 8.7 | 4.5 |
| | External quantum (%) efficiency at 900 nm | 0.04 | 0.02 | 0.2 | 0.04 |

(continued)

| | | Example 1 | Example 2 | Comparative Example 1 | Comparative Example 2 |
|---|---|---|---|---|---|
| Perovskite (P) | Compound | $CH_3NH_3PbBr_3$ | $CH_3NH_3PbI_3$ | $CH_3NH_3PbBr_3$ | $CH_3NH_3PbI_3$ |
| | Band gap energy (eV) | 2.3 | 1.6 | 2.3 | 1.6 |
| Light absorption layer | oleate anion/quantum dot (molar Pb ratio) | 0.10 | 0.09 | 0.47 | 0.45 |
| | oleate anion/perovskite Po (molar ratio) | 0.01 | 0. 01 | 0.07 | 0.07 |
| | Absorbance ratio (QD/P) | 0 | 0 | 0 | 0 |
| | Perovskite absorbance | 0.29 | 0.08 | 0.07 | 0.12 |
| | Emission peak energy (eV) | 0.93 | 0.97 | 0.93 | 0.97 |
| | Emission peak shift (eV) | 0.05 | 0.01 | 0.27 | 0.23 |
| | T-iickness (nm) | <100 | <100 | <100 | <100 |
| | Surface smoothness (nm) | 119 | 251 | 79 | 739 |
| | Coverage (%) | 40 | 70 | 5 | 60 |
| | Crystallite diameter (nm) | 43 | 28 | 15 | 25 |

INDUSTRIAL APPLICABILITY

The light absorption layer and the photoelectric conversion element of the present invention can be suitably used as a constituent member of a next generation solar cell.

DESCRIPTION OF REFERENCE SIGNS

1    Photoelectric conversion element
2    Transparent substrate
3    Transparent conductive layer
4    Blocking layer
5    Porous layer
6    Light absorption layer
7    Hole transport layer
8    Electrode (positive electrode)
9    Electrode (negative electrode)
10   Light

**Claims**

1.  A light absorption layer, comprising a perovskite compound, and a quantum dot containing a halogen element and an organic ligand, **characterized in that**

    a molar ratio of the organic ligand to a metal element constituting the quantum dot is 0.01 or more and 0.4 or less, wherein the quantum dot containing the halogen element and the organic ligand is such that a molar ratio of the organic ligand to a metal element constituting the perovskite compound is 0.001 or more and 0.1 or less.

2. The light absorption layer according to claim 1, wherein the molar ratio of the organic ligand to the metal element constituting the quantum dot containing the halogen element and the organic ligand is 0.05 or more and 0.3 or less.

3. The light absorption layer according to claim 1 or 2, wherein the perovskite compound is one or more kinds selected from a compound represented by the following general formula (1) and a compound represented by the following general formula (2):

$$RMX_3 \qquad (1)$$

wherein R is a monovalent cation, M is a divalent metal cation, and X is a halogen anion, and

$$R^1R^2R^3{}_{n-1}M_nX_{3n+1} \qquad (2)$$

wherein $R^1$, $R^2$ and $R^3$ are each independently a monovalent cation, M is a divalent metal cation, X is a halogen anion, and n is an integer of 1 to 10.

4. The light absorption layer according to any one of claims 1 to 3, wherein a band gap energy of the perovskite compound is 1.5 eV or more and 4.0 eV or less.

5. The light absorption layer according to any one of claims 1 to 4, wherein a band gap energy of the quantum dot containing the halogen element and the organic ligand is 0.2 eV or more and no more than a band gap energy of the perovskite compound.

6. The light absorption layer according to any one of claims 1 to 5, wherein the quantum dot containing the halogen element and the organic ligand contains a metal oxide or a metal chalcogenide.

7. The light absorption layer according to any one of claims 1 to 6, wherein the quantum dot containing the halogen element and the organic ligand is a compound in which the halogen element and the organic ligand are coordinated to a surface of a metal oxide or a metal chalcogenide.

8. The light absorption layer according to any one of claims 1 to 7, wherein the quantum dot containing the halogen element and the organic ligand contains Pb element.

9. The light absorption layer according to any one of claims 1 to 8, wherein a content ratio of the quantum dot containing the halogen element and the organic ligand to a total content of the perovskite compound and the quantum dot containing the halogen element and the organic ligand is 0.1% by mass or more and 10% by mass or less.

10. The light absorption layer according to any one of claims 1 to 9, wherein the quantum dot containing the halogen element and the organic ligand is such that an atomic ratio of the halogen element to a metal element constituting the quantum dot is 0.1 or more and 1 or less.

11. A dispersion, comprising a perovskite compound, and a quantum dot containing a halogen element and an organic ligand, **characterized in that** a molar ratio of the organic ligand to a metal element constituting the quantum dot is 0.01 or more and 0.4 or less, and
wherein the quantum dot containing the halogen element and the organic ligand is such that a molar ratio of the organic ligand to a metal element constituting the perovskite compound is 0.001 or more and 0.1 or less.

12. A method for manufacturing a light absorption layer containing a perovskite compound, and a quantum dot containing a halogen element and an organic ligand as defined in any one of the claims 1 to 10, comprising a step of mixing the perovskite compound or its precursor with the quantum dot containing the halogen element and the organic ligand.

13. A photoelectric conversion element having the light absorption layer according to any one of claims 1 to 10.

14. A solar cell having the photoelectric conversion element according to claim 13.

**Patentansprüche**

1. Lichtabsorptionsschicht, die eine Perovskitverbindung und einen Quantenpunkt, der ein Halogenelement und einen organischen Liganden enthält, umfasst, **dadurch gekennzeichnet, dass** ein Molverhältnis des organischen Liganden zu einem Metallelement, das den Quantenpunkt bildet, 0,01 oder mehr und 0,4 oder weniger beträgt, wobei der Quantenpunkt, der das Halogenelement und den organischen Liganden enthält, so beschaffen ist, dass ein Molverhältnis des organischen Liganden zu einem Metallelement, das die Perovskitverbindung bildet, 0,001 oder mehr und 0,1 oder weniger beträgt.

2. Lichtabsorptionsschicht gemäß Anspruch 1, wobei das Molverhältnis des organischen Liganden zu dem Metallelement, das den Quantenpunkt, der das Halogenelement und den organischen Liganden enthält, bildet, 0,05 oder mehr und 0,3 oder weniger beträgt.

3. Lichtabsorptionsschicht gemäß Anspruch 1 oder 2, wobei die Perovskitverbindung eine oder mehrere Arten ist, ausgewählt aus einer Verbindung mit der folgenden allgemeinen Formel (1) und einer Verbindung mit der folgenden allgemeinen Formel (2):

$$RMX_3 \qquad (1)$$

worin R ein monovalentes Kation ist, M ein divalentes Metallkation ist und X ein Halogenanion ist, und

$$R^1R^2R^3_{n-1}M_nX_{3n+1} \qquad (2)$$

worin $R^1$, $R^2$ und $R^3$ jeweils ein monovalentes Kation sind, M ein divalentes Metallkation ist, X ein Halogenanion ist und n eine ganze Zahl von 1 bis 10 ist.

4. Lichtabsorptionsschicht gemäß mindestens einem der Ansprüche 1 bis 3, wobei eine Bandlückenenergie der Perovskitverbindung 1,5 eV oder mehr und 4,0 eV oder weniger beträgt.

5. Lichtabsorptionsschicht gemäß mindestens einem der Ansprüche 1 bis 4, wobei eine Bandlückenenergie des Quantenpunkts, der das Halogenelement und den organischen Liganden enthält, 0,2 eV oder mehr und nicht mehr als die Bandlückenenergie der Perovskitverbindung beträgt.

6. Lichtabsorptionsschicht gemäß mindestens einem der Ansprüche 1 bis 5, wobei der Quantenpunkt, der das Halogenelement und den organischen Liganden enthält, ein Metalloxid oder ein Metallchalcogenid enthält.

7. Lichtabsorptionsschicht gemäß mindestens einem der Ansprüche 1 bis 6, wobei der Quantenpunkt, der das Halogenelement und den organischen Liganden enthält, eine Verbindung ist, in der das Halogenelement und der organische Ligand an eine Oberfläche eines Metalloxids oder eines Metallchalkogenids koodiniert sind.

8. Lichtabsorptionsschicht gemäß mindestens einem der Ansprüche 1 bis 7, wobei der Quantenpunkt, der das Halogenelement und den organischen Liganden enthält, ein Pb Element enthält.

9. Lichtabsorptionsschicht gemäß mindestens einem der Ansprüche 1 bis 8, wobei ein Massenverhältnis des Quantenpunkts, der das Halogenelement und den organischen Liganden enthält, zu einem Gesamtgehalt der Perovskitverbindung und des Quantenpunkts, der das Halogenelement und den organischen Liganden enthält, 0,1 Massen-% oder mehr und 10 Massen-% oder weniger beträgt.

10. Lichtabsorptionsschicht gemäß mindestens einem der Ansprüche 1 bis 9, wobei der Quantenpunkt, der das Halogenelement und den organischen Liganden enthält, so beschaffen ist, dass ein Atomverhältnis des Halogenelements zu einem Metallelement, das den Quantenpunkt bildet, 0,1 oder mehr und 1 oder weniger beträgt.

11. Dispersion, die eine Perovskitverbindung und einen Quantenpunkt, der ein Halogenelement und einen organischen Liganden enthält, umfasst, **dadurch gekennzeichnet, dass** ein Molverhältnis des organischen Liganden zu einem Metallelement, das den Quantenpunkt bildet, 0,01 oder mehr und 0,4 oder weniger beträgt, wobei der Quantenpunkt, der das Halogenelement und den organischen Liganden enthält, so beschaffen ist, dass ein Molverhältnis des organischen Liganden zu einem Metallelement, das die Perovskitverbindung bildet, 0,001 oder mehr und 0,1 oder weniger beträgt.

**12.** Verfahren zur Herstellung einer Lichtabsorptionsschicht, die eine Perovskitverbindung und einen Quantenpunkt, der ein Halogenelement und einen organischen Liganden enthält, umfasst wie in mindestens einem der Ansprüche 1 bis 10 definiert, umfassend einen Schritt, in dem die Perovskitverbindung oder sein Vorläufer mit dem Quantenpunkt, der das Halogenelement und den organischen Liganden enthält, gemischt wird.

**13.** Photoelektrisches Umwandlungselement mit der Lichtabsorptionsschicht gemäß mindestens einem der Ansprüche 1 bis 10.

**14.** Solarzelle mit dem photoelektrischen Umwandlungselement gemäß Anspruch 13.

**Revendications**

**1.** Couche d'absorption de lumière, comprenant un composé de pérovskite, et un point quantique contenant un élément halogène et un ligand organique, **caractérisée en ce qu'**un rapport molaire du ligand organique par rapport à un élément métallique constituant le point quantique est de 0,01 ou plus et de 0,4 ou moins, dans laquelle le point quantique contenant l'élément halogène et le ligand organique est tel qu'un rapport molaire du ligand organique par rapport à un élément métallique constituant le composé de pérovskite est de 0,001 ou plus et de 0,1 ou moins.

**2.** Couche d'absorption de lumière selon la revendication 1, dans laquelle le rapport molaire du ligand organique par rapport à l'élément métallique constituant le point quantique contenant l'élément halogène et le ligand organique est de 0,05 ou plus et de 0,3 ou moins.

**3.** Couche d'absorption de lumière selon la revendication 1 ou 2, dans laquelle le composé de pérovskite est un ou plusieurs types choisis parmi un composé représenté par la formule générale (1) suivante et un composé représenté par la formule générale (2) suivante :

$$RMX_3 \qquad (1)$$

dans laquelle R est un cation monovalent, M est un cation métallique divalent, et X est un anion halogène, et

$$R^1R^2R^3_{n-1}M_nX_{3n+1} \qquad (2)$$

dans laquelle $R^1$, $R^2$ et $R^3$ sont chacun indépendamment un cation monovalent, M est un cation métallique divalent, X est un anion halogène, et n est un nombre entier de 1 à 10.

**4.** Couche d'absorption de lumière selon l'une quelconque des revendications 1 à 3, dans laquelle une énergie de bande interdite du composé de pérovskite est de 1,5 eV ou plus et de 4,0 eV ou moins.

**5.** Couche d'absorption de lumière selon l'une quelconque des revendications 1 à 4, dans laquelle une énergie de bande interdite du point quantique contenant l'élément halogène et le ligand organique est de 0,2 eV ou plus et pas plus qu'une énergie de bande interdite du composé de pérovskite.

**6.** Couche d'absorption de lumière selon l'une quelconque des revendications 1 à 5, dans laquelle le point quantique contenant l'élément halogène et le ligand organique contient un oxyde métallique ou un chalcogénure métallique.

**7.** Couche d'absorption de lumière selon l'une quelconque des revendications 1 à 6, dans laquelle le point quantique contenant l'élément halogène et le ligand organique est un composé dans lequel l'élément halogène et le ligand organique sont coordonnés à une surface d'un oxyde métallique ou d'un chalcogénure métallique.

**8.** Couche d'absorption de lumière selon l'une quelconque des revendications 1 à 7, dans laquelle le point quantique contenant l'élément halogène et le ligand organique contient un élément Pb.

**9.** Couche d'absorption de lumière selon l'une quelconque des revendications 1 à 8, dans laquelle un rapport de teneur du point quantique contenant l'élément halogène et le ligand organique à une teneur totale du composé de pérovskite et du point quantique contenant l'élément halogène et le ligand organique est de 0,1 % en masse ou plus et de 10 % en masse ou moins.

**10.** Couche d'absorption de lumière selon l'une quelconque des revendications 1 à 9, dans laquelle le point quantique contenant l'élément halogène et le ligand organique est tel qu'un rapport atomique de l'élément halogène à un élément métallique constituant le point quantique est de 0,1 ou plus et de 1 ou moins.

**11.** Dispersion comprenant un composé de pérovskite et un point quantique contenant un élément halogène et un ligand organique, **caractérisée en ce qu'**un rapport molaire du ligand organique par rapport à un élément métallique constituant le point quantique est de 0,01 ou plus et de 0,4 ou moins, et
dans laquelle le point quantique contenant l'élément halogène et le ligand organique est tel qu'un rapport molaire du ligand organique par rapport à un élément métallique constituant le composé de pérovskite est de 0,001 ou plus et de 0,1 ou moins.

**12.** Procédé de fabrication d'une couche d'absorption de lumière contenant un composé de pérovskite, et un point quantique contenant un élément halogène et un ligand organique tel que défini dans l'une quelconque des revendications 1 à 10, comprenant une étape de mélange du composé de pérovskite ou de son précurseur avec le point quantique contenant l'élément halogène et le ligand organique.

**13.** Elément de conversion photoélectrique présentant la couche d'absorption de lumière selon l'une quelconque des revendications 1 à 10.

**14.** Cellule solaire présentant l'élément de conversion photoélectrique selon la revendication 13.

Fig.1

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 2016380136 A1

### Non-patent literature cited in the description

- *ACS Nano,* 2014, vol. 8, 614-622
- *J. Am. Chem. Soc.,* 2009, vol. 131, 6050-6051
- *Nano Lett.,* 2015, vol. 15, 7539-7543
- *J. Phys. Chem.,* 2015, vol. 119 (42), 24149-24155
- *ACS Nano,* 2014, vol. 8, 6363-6371
- *Chemical Review,* 2010, vol. 110, 6595